# EUROPÄISCHE PATENTSCHRIFT

(11) **EP 2 622 622 B1**
(45) Veröffentlichungstag und Bekanntmachung des Hinweises auf die Patenterteilung: **15.10.2014**
(21) Anmeldenummer: 11773373.3
(22) Anmeldetag: 13.09.2011
(51) Int. Cl.: H01H 83/14, H02H 3/05, H01H 83/04

(54) **FEHLERSTROMSCHUTZSCHALTER**
RESIDUAL CURRENT OPERATED DEVICE
INTERRUPTEUR DE PROTECTION DE COURANT RÉSIDUEL

(30) Priorität: 28.09.2010 AT 16202010
(43) Veröffentlichungstag der Anmeldung: 07.08.2013
(73) Patentinhaber: Eaton Industries (Austria) GmbH, 3943 Schrems (AT)
(72) Erfinder: DOBUSCH, Gerhard, A-1180 Wien (AT); KOLM, Roman, A-3931 Schweiggers (AT)
(74) Vertreter: Eaton IP Group EMEA
(86) Internationale Anmeldenummer: PCT/AT2011/000372
(87) Internationale Veröffentlichungsnummer: WO 2012/040750

(56) Entgegenhaltungen:
- EP-A1- 1 562 213
- EP-A2- 2 107 662
- DE-B3-102008 006 360

## Beschreibung

Die Erfindung betrifft einen Fehlerstromschutzschalter gemäß dem Oberbegriff des Patentanspruches 1. Fehlerstromschutzschalter weisen in der Regel eine Prüfeinrichtung auf, um die Wirksamkeit der Auslösung des betreffenden Fehlerstromschutzschalters beim Auftreten eines Fehlerstromes zu überprüfen. Dabei wird etwa mittels eines Tasters ein Stromkreis geschlossen, in welchem ein Strom an einem Fehlerstromdetektor, etwa einem Summenstromwandler, vorbei geführt wird. Ein derartiger Strom wird von einem funktionierenden Fehlerstromschutzschalter als Fehlerstrom erkannt, woraufhin bei einem funktionierenden Fehlerstromschutzschalter die Schaltkontakte getrennt werden, und das nachfolgende und durch den Fehlerstromschutzschalter zu schützende elektrische Netz abgeschaltet bzw. von einem anderen vorgeschalteten elektrischen Netz getrennt wird. Aus dem Stand der Technik sind solche Schalter beispielsweise aus EP2107662A2, DE102008006360B3 und EP1562213A1 bekannt. Nachteilig daran ist, dass sämtliche an das betreffende zu schützende Netz angeschlossenen elektrischen Komponenten, bei einer einwandfreien Funktion des betreffenden Fehlerstromschutzschalters, für eine gewisse Zeitspanne bis zum erneuten Einschalten des betreffenden Fehlerstromschutzschalters stromlos und daher ausgeschaltet sind. Moderne Haushalte weisen zahlreiche elektrische Geräte auf, welche eine ständige Versorgung mit elektrischer Energie erfordern, und welche nach einem Stromausfall, mehr oder weniger aufwändig, einzeln manuell wieder in Betrieb genommen werden müssen. Neben den bei zahlreichen Geräten vorherrschenden Uhren, welche ein erneutes Einstellen der Uhrzeit erforderlich machen, verlieren etwa programmierbare Geräte, wie etwa Audio-, Video- und/oder Fernsehgeräte, deren durch den Benutzer vorgenommene Einstellungen. Während der Verlust der Uhrzeit und der persönlichen Einstellungen an elektronischen Geräten zwar für den einzelnen Benutzer unangenehm ist, und einen Hauptgrund für die geringe Akzeptanz der Funktionsprüfung bei Fehlerstromschutzschaltern darstellt, kann die Unterbrechung der Stromzufuhr im Zuge der Funktionsprüfung des Fehlerstromschutzschalters weiters zu Sicherheitsrisiken führen, wenn - etwa aus Unkenntnis der tatsächlich von der Funktionsprüfung betroffenen Stromkreise - Maschinen während des Betriebs ausgeschaltet werden.

Aufgabe der Erfindung ist es daher einen Fehlerstromschutzschaltern der eingangs genannten Art anzugeben, mit welchem die genannten Nachteile vermieden werden können, bei welchem eine Funktionsprüfung ohne Unterbrechung des nachgeschalteten elektrischen Netzes erfolgen kann, und welcher eine kompakte Bauform aufweist.

Erfindungsgemäß wird dies durch die Merkmale des Patentanspruches 1 erreicht.

Dadurch kann ein Fehlerstromschutzschalter gebildet werden, bei welchem eine Funktionsprüfung durchgeführt werden kann, ohne dass dies zwangsläufig zu einer Unterbrechung des Stromflusses in dem nachgeschalteten elektrischen Netz führt. Da dadurch auf das erneute Programmieren elektronischer Geräte als Folge eines Stromausfalles verzichtet werden kann, weist die Funktionsprüfung derartiger Fehlerstromschutzschalter einen höheren Zuspruch auf, als die Funktionsprüfung herkömmlicher Fehlerstromschutzschalter. Dadurch werden defekte Fehlerstromschutzschalter früher als bisher als solche identifiziert, und können ausgetauscht werden. Dadurch steigt die Sicherheit elektrischer Anlagen. Dadurch kann etwa die Funktionsprüfung automatisiert zu bestimmten Zeitpunkten selbsttätig durch den betreffenden Fehlerstromschutzschalter durchgeführt werden.

Durch die Ausbildung des ersten Auslösestromkreises als netzspannungsunabhängiger Auslösestromkreis, welcher den zu schützenden Stromkreis im normalen Betrieb des Fehlerstromschutzschalters hinsichtlich auftretender Fehlerströme überwacht, kann ein derartiger Fehlerstromschutzschalter auch in Ländern eingesetzt werden, welche entsprechende nationale bzw. regionale Vorschriften hinsichtlich der vorgeschriebenen Verwendung netzspannungsunabhängiger Fehlerstromschutzschalter aufweisen. Durch die Netzspannungsabhängigkeit des zweiten Auslösestromkreises kann der zweite Fehlerstromsensor kleiner ausgebildet werden, als der erste Fehlerstromsensor, da das durch den zweiten Fehlerstromsensor ermittelte zweite Fehlerstromsignal, aufgrund der nachfolgenden aktiven Signalverstärkung, leistungsschwächer sein kann, als das durch den ersten Fehlerstromsensor ermittelte erste Fehlerstromsignal. Vor allem bei der bevorzugten Ausbildung des ersten und des zweiten Fehlerstromsensors als Summenstromwandler kann der zweite Fehlerstromsensor deutlich kleiner und platzsparender ausgebildet sein, wobei weiters geringere Anforderungen an das verwendete Kernmaterial gestellt wird, wodurch auch die Kosten für einen derart ausgebildeten zweiten Fehlerstromsensor gering ausfallen. Dadurch kann die Gesamtbaugröße des Fehlerstromschutzschalters gering gehalten werden. Der gegenständliche Fehlerstromschutzschalter ist ungeachtet der Netzspannungsabhängigkeit des zweiten Auslösekreises ein sog. netzspannungsunabhängiger Fehlerstromschutzschalter, da ausschließlich während des Vorgangs der Funktionsprüfung und eben nur für diesen Vorgang Netzspannung erforderlich ist, wie dies bei sämtlichen Fehlerstromschutzschaltern bei einer entsprechenden Funktionsprüfung der Fall ist.

Die Unteransprüche, welche ebenso wie der Patentanspruch 1 gleichzeitig einen Teil der Beschreibung bilden, betreffen weitere vorteilhafte Ausgestaltungen der Erfindung.

Die Erfindung betrifft weiters ein Verfahren zur Funktionsprüfung eines Fehlerstromschutzschalters gemäß dem Oberbegriff des Patentanspruches 8.

Aufgabe der Erfindung ist es ein Verfahren der vorstehend genannten Art anzugeben, mit welchem die genannten Nachteile vermieden werden können, bei welchem eine Funktionsprüfung ohne Unterbrechung des nachgeschalteten elektrischen Netzes erfolgen kann, und mit welchem eine kompakte Bauform eines Fehlerstromschutzschalters unterstützt wird.

Erfindungsgemäß wird dies durch die Merkmale des Patentanspruches 8 erreicht.

Dadurch ergeben sich die vorstehend zu Patentanspruch 1 genannten vorteilhaften Wirkungen.

Die Unteransprüche, welche ebenso wie der Patentanspruch 8 gleichzeitig einen Teil der Beschreibung bilden, betreffen weitere vorteilhafte Ausgestaltungen der Erfindung.

Die Erfindung wird unter Bezugnahme auf die beigeschlossenen Zeichnungen, in welchen eine lediglich bevorzugte Ausführungsform beispielhaft dargestellt ist, näher beschrieben. Dabei zeigt:
Fig. 1 eine bevorzugte Ausführungsform eines erfindungsgemäßen Fehlerstromschutzschalters im spannungsfreien Zustand als schematische Darstellung;
Fig. 2 der Fehlerstromschutzschalter gemäß Fig. 1 im Normalbetrieb als schematische Darstellung; und
Fig. 3 der Fehlerstromschutzschalter gemäß Fig. 1 während eines Prüfvorganges als schematische Darstellung.

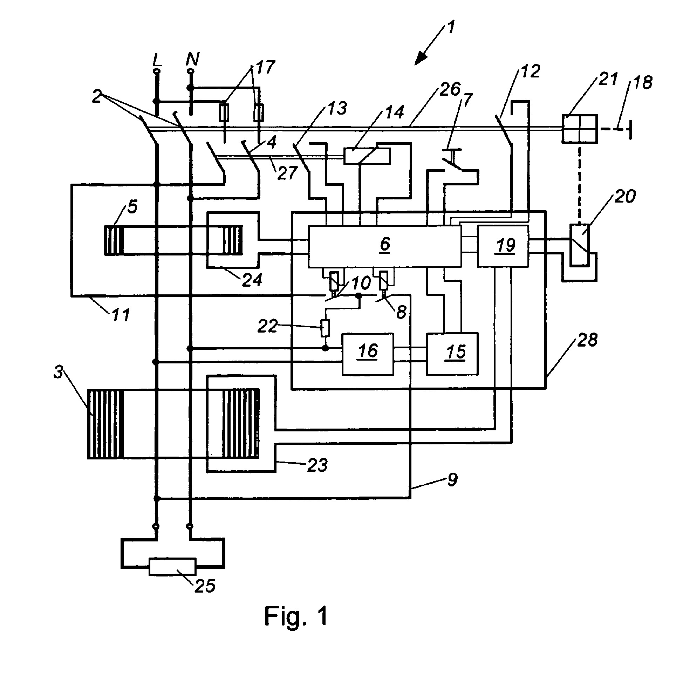

Die Fig. 1 bis 3 zeigen einen Fehlerstromschutzschalter 1 mit einem ersten Auslösestromkreis und einem zweiten Auslösestromkreis, wobei der Fehlerstromschutzschalter 1 vorgebbar trennbare erste Trennkontakte 2 aufweist, wobei der erste Auslösestromkreis wenigstens einen ersten Fehlerstromsensor 3 aufweist, und zum netzspannungsunabhängigen Öffnen der ersten Trennkontakte 2 beim Auftreten eines Fehlerstromes vorgebbarer Größe mit den ersten Trennkontakten 2 wirkverbunden ist, wobei der Fehlerstromschutzschalter 1 vorgebbar betätigbare zweite Trennkontakte 4 aufweist, welche im geschlossenen Zustand die ersten Trennkontakte 2 überbrücken, wobei der zweite Auslösestromkreis wenigstens einen zweiten Fehlerstromsensor 5 aufweist, wobei der zweite Fehlerstromsensor 5 wenigstens mittelbar mit einer Steuereinheit 6 schaltungstechnisch verbunden ist, wobei die Steuereinheit 6 mit den zweiten Trennkontakten 2 wirkverbunden ist, wobei der Fehlerstromschutzschalter 1 eine Prüfanordnung zur Funktionsprüfung des ersten und des zweiten Auslösestromkreises aufweist, wobei die Prüfanordnung einen Prüftaster 7 aufweist, welcher auf die Steuereinheit 6 wirkt, wobei die Steuereinheit 6 mit einem ersten Prüfschalter 8 wirkverbunden ist, welcher erste Prüfschalter 8 Teil eines ersten Prüfstrompfades 9 zum Erzeugen eines, auf den ersten Auslösestromkreis wirkenden ersten simulierten Fehlerstroms ist, und wobei die Steuereinheit 6 mit einem zweiten Prüfschalter 10 wirkverbunden ist, welcher zweite Prüfschalter 10 Teil eines zweiten Prüfstrompfades 11 zum Erzeugen eines, auf den zweiten Auslösestromkreis wirkenden zweiten simulierten Fehlerstroms ist.

Dadurch kann ein Fehlerstromschutzschalter 1 gebildet werden, bei welchem eine Funktionsprüfung durchgeführt werden kann, ohne dass dies zwangsläufig zu einer Unterbrechung des Stromflusses in dem nachgeschalteten elektrischen Netz führt. Da dadurch auf das erneute Programmieren elektronischer Geräte als Folge eines Stromausfalles verzichtet werden kann, weist die Funktionsprüfung derartiger Fehlerstromschutzschalter 1 einen höheren Zuspruch auf, als die Funktionsprüfung herkömmlicher Fehlerstromschutzschalter. Dadurch werden defekte Fehlerstromschutzschalter 1 früher als bisher als solche identifiziert, und können ausgetauscht werden. Dadurch steigt die Sicherheit elektrischer Anlagen. Dadurch kann etwa die Funktionsprüfung automatisiert zu bestimmten Zeitpunkten selbsttätig durch den betreffenden Fehlerstromschutzschalter 1 durchgeführt werden.

Durch die Ausbildung des ersten Auslösestromkreises als netzspannungsunabhängiger Auslösestromkreis, welcher den zu schützenden Stromkreis im normalen Betrieb des Fehlerstromschutzschalters 1 hinsichtlich auftretender Fehlerströme überwacht, kann ein derartiger Fehlerstromschutzschalter 1 auch in Ländern eingesetzt werden, welche entsprechende nationale bzw. regionale Vorschriften hinsichtlich der vorgeschriebenen Verwendung netzspannungsunabhängiger Fehlerstromschutzschalter 1 aufweisen. Durch die Netzspannungsabhängigkeit des zweiten Auslösestromkreises kann der zweite Fehlerstromsensor 5 kleiner ausgebildet werden, als der erste Fehlerstromsensor 3, da das durch den zweiten Fehlerstromsensor 5 ermittelte zweite Fehlerstromsignal, aufgrund der nachfolgenden aktiven Signalverstärkung, leistungsschwächer sein kann, als das durch den ersten Fehlerstromsensor 3 ermittelte erste Fehlerstromsignal. Vor allem bei der bevorzugten Ausbildung des ersten und des zweiten Fehlerstromsensors 3, 5 als Summenstromwandler kann der zweite Fehlerstromsensor 5 deutlich kleiner und platzsparender ausgebildet sein, wobei weiters geringere Anforderungen an das verwendete Kernmaterial gestellt wird, wodurch auch die Kosten für einen derart ausgebildeten zweiten Fehlerstromsensor 5 gering ausfallen. Dadurch kann die Gesamtbaugröße des Fehlerstromschutzschalters 1 gering gehalten werden. Der gegenständliche Fehlerstromschutzschalter 1 ist ungeachtet der Netzspannungsabhängigkeit des zweiten Auslösekreises ein sog. netzspannungsunabhängiger Fehlerstromschutzschalter 1, da ausschließlich während des Vorgangs der Funktionsprüfung, und eben nur für diesen Vorgang, Netzspannung erforderlich ist, wie dies bei sämtlichen Fehlerstromschutzschaltern 1 bei einer entsprechenden Funktionsprüfung der Fall ist.

Bei einem derartigen Fehlerstromschutzschalter 1 wird zur Funktionsprüfung ohne Unterbrechung des nachgeschalteten elektrischen Netzes, sowie zum Erzielen einer kompakte Bauform vorgeschlagen, dass der Fehlerstromschutzschalter 1 zwei separate Auslösestromkreise aufweist, wobei ein erster Auslösestromkreis netzspannungsunabhängig ausgebildet ist, und wobei ein zweiter Auslösestromkreis netzspannungsabhängig ausgebildet ist, und wobei während der Funktionsprüfung des einen Auslösestromkreises der jeweils andere Auslösestromkreis das zu schützende elektrische Netz auf Fehlerströme überwacht. Die Fig. 1 bis 3 zeigen eine besonders bevorzugte Ausführungsform eines erfindungsgemäßen Fehlerstromschutzschalters 1 in jeweils unterschiedlichen Betriebszuständen. Nachfolgend wird der bevorzugte Aufbau eines erfindungsgemäßen Fehlerstromschutzschalters 1 anhand der Fig. 1 bis 3 erläutert.

Fehlerstromschutzschalter 1 sind zum Schutz eines elektrischen Netzes bzw. eines Teilnetzes vor Fehlerströmen bzw. Erdfehlerströmen vorgesehen. Ein elektrisches Netz weist dabei bevorzugt wenigstens zwei Leiter L, N auf, wobei auch Ausführungsformen mit mehr Leitern, etwa drei oder vier, vorgesehen sein können. Der Fehlerstromschutzschalter 1 weist nicht dargestellte Eingangs- und Ausgangsklemmen zum Anschluss der Leiter L, N auf. Der Fehlerstromschutzschalter 1 weist weiters erste Trennkontakte 2 auf, welche dazu ausgebildet sind im Fehlerfall getrennt zu werden, und das zu schützende Netz abzuschalten bzw. zu trennen.

Weiters weist der Fehlerstromschutzschalter 1 einen ersten und einen zweiten Fehlerstromsensor 3, 5 auf, welche bevorzugt als Summenstromwandler ausgebildet sind, wobei auch andere Ausführungen der Fehlerstromsensoren 3, 5 vorgesehen sein können. Dabei kann auch vorgesehen sein die beiden Fehlerstromsensoren 3, 5 jeweils unterschiedlich auszubilden, etwa kann vorgesehen sein den ersten Fehlerstromsensor 3 als Summenstromwandler auszubilden, und den zweiten Fehlerstromsensor 5 als Förstersonde bzw. als Anordnung von Shunt-Widerständen. Die Summenstromwandler weisen jeweils einen bevorzugt ringförmigen Kern mit einer Durchführungsöffnung auf, durch welche die Leiter L, N des zu überwachenden bzw. schützenden Netzes geführt sind. In den Fig. 1 bis 3 sind die als Summenstromwandler ausgebildeten ersten und zweiten Fehlerstromdetektoren 3, 5 als schematische Schnittdarstellung des Kerns dargestellt.

Erfindungsgemäße Fehlerstromschutzschalter 1 weisen einen ersten und einen zweiten Auslösestromkreis auf.

Der erste Auslösestromkreis ist dazu vorgesehen im regulären Betrieb des erfindungsgemäßen Fehlerstromschutzschalters 1, daher im Betrieb außerhalb des Prüfvorganges, das zu schützende elektrische Netz auf das Auftreten von Fehlerströmen zu überwachen, und umfasst den bevorzugt als Summenstromwandler ausgebildeten ersten Fehlerstromsensor 3. Um den Kern des Summenstromwandlers ist eine sog. erste Sekundärwicklung 23 angeordnet, in welcher beim Auftreten eines Fehlerstromes ein erstes Fehlerstromsignal erzeugt wird. Der erste Auslösestromkreis ist als sog. netzspannungsunabhängiger Auslösestromkreis ausgebildet, daher zum netzspannungsunabhängigen Öffnen der ersten Trennkontakte 2 beim Auftreten eines Fehlerstromes vorgebbarer Größe. Da dabei die gesamte, zum Auslösen des Fehlerstromschutzschalters 1 erforderliche Energie dem ersten Fehlerstromsignal entnommen wird, weist der Kern des ersten Summenstromwandlers bevorzugt einen hochwertigen Magnetwerkstoff auf. Auch muss der Kern eine gewisse Größe aufweisen, um im Fehlerfall ein erstes Fehlerstromsignal zu erzeugen, welches die notwendige Leistung aufweist, um nachfolgend ein Öffnen der ersten Trennkontakte 2 zu verursachen.

Die erste Sekundärwicklung 23 ist bevorzugt an eine Auslöseeinheit 19 angeschlossen, in welcher bevorzugt ein Energiespeicherelement, etwa ein Kondensator, sowie eine Komparatorschaltung angeordnet ist, um das erste Fehlerstromsignal mit einem Referenzsignal zu vergleichen. Die Auslöseeinheit 19 ist gemäß den Fig. 1 bis 3 an ein Auslöserelais 20 angeschlossen, welches etwa auch als Permanentmagnetauslöser ausgebildet sein kann, und welches mechanisch auf ein Schaltschloss 21 einwirkt. Beim Auftreten eines Fehlerstromes wird in der ersten Sekundärwicklung 23 ein erstes Fehlerstromsignal erzeugt, welches in der Auslöseeinheit 19 mit einem Referenzsignal verglichen wird. Übersteigt das erste Fehlerstromsignal das Referenzsignal, wird das Auslöserelais 20 betätigt, welches auf das Schaltschloss 21 einwirkt und dieses entklinkt, was wiederum ein Öffnen der ersten Trennkontakte 2 verursacht. Der Handbetätigungshebel 18 ist mit dem Schaltschloss verbunden. Mit diesem können die ersten Trennkontakte wieder geschlossen, und das Schaltschloss 21 verklinkt werden.

Der zweite Auslösestromkreis weist einen bevorzugt ebenfalls als Summenstromwandler ausgebildeten zweiten Fehlerstromsensor 5 auf, um dessen Kernquerschnitt eine zweite Sekundärwicklung 24 angeordnet ist, welche an eine Steuereinheit 6 angeschlossen ist, welche bevorzugt als programmierbare Logikschaltung und/oder Mikrocontroller ausgebildet ist bzw. einen solchem mit umfasst. Weiters weist die Steuereinheit 6 bevorzugt eine Verstärkerschaltung auf, um das eingehende zweite Fehlerstromsignal aktiv zu verstärken. Dadurch kann der Kern des als Summenstromwandler ausgebildeten zweiten Fehlerstromsensors 5 deutlich kleiner und mit weniger hochwertigem Magnetwerkstoff ausgebildet werden, als der Kern des als Summenstromwandler ausgebildeten ersten Fehlerstromsensors 3.

Zur Energieversorgung der Steuereinheit 6 ist ein Netzteil 16 vorgesehen, welches mit wenigstens zwei Leitern L, N des zu schützenden Netzes verbunden ist. Das Netzteil 16 ist bevorzugt dazu ausgebildet die netzseitige Spannung für die Versorgung der Steuereinheit 6 aufzubereiten. Besonders bevorzugt weist das Netzteil 16 einen Gleichrichter auf. Bevorzugt ist vorgesehen, dass die Steuereinheit 6 mit einem Energiespeicherelement 15, insbesondere einen Akkumulator oder einen Kondensator, schaltungstechnisch verbunden ist, welches Energiespeicherelement 15 mit dem Netzteil 16 verbunden ist. Dadurch kann auch bei einem Verlust der Netzspannung während des Betriebes des zweiten Auslösestromkreises ein weiterer Betrieb der Steuereinheit 6 gewährleistet werden. Dadurch ist auch der zweite Auslösestromkreis von der Netzspannung unabhängig, da die für den zeitlich begrenzten Betrieb des zweiten Auslösestromkreises bzw. der Steuereinheit 6 erforderliche Energie dem Energiespeicherelement 15 entnommen wird, und daher unabhängig von der Netzspannung bereit steht.

Ein erfindungsgemäßer Fehlerstromschutzschalter 1 weist neben den bereits dargelegten ersten Trennkontakten 2, weiters zweite Trennkontakte 4 auf, welche im geschlossenen Zustand die ersten Trennkontakte 2 überbrücken. Die zweiten Trennkontakte 4 sind mit der Steuereinheit 6 wirkverbunden, und von dieser vorgebbar betätigbar. Hiezu ist gemäß der dargestellten bevorzugten Ausführungsform ein zweiter Aktuator 14 vorgesehen, welcher von der Steuereinheit 6 angesteuert wird, und mit welchem die zweiten Trennkontakte 4 geöffnet bzw. geschlossen werden können. Der zweite Aktuator 14 ist, wie in den Fig. 1 bis 3 durch eine doppelte Linie veranschaulicht, mit den zweiten Trennkontakten 4 mechanisch gekoppelt.

Die zweiten Trennkontakte 4 sind dazu vorgesehen die ersten Trennkontakte 2 für die Zeitdauer der Prüfung des ersten Auslösestromkreises zu überbrücken, und für diese begrenzte Zeitdauer, welche bevorzugt unter einer Sekunde liegt, den Stromfluss durch den Fehlerstromschutzschalter 1 zu gewährleisten und diesen im Fehlerfall zu unterbrechen. In den Fig. 1 bis 3 ist die Überbrückung der ersten Trennkontakte 2 durch die zweiten Trennkontakte ersichtlich. Aufgrund der geringen zeitlichen Dauer eines allfälligen Stromflusses über die zweiten Trennkontakte 4 können diese kleiner und mit weniger hochwertigen Werkstoffen ausgebildet werden, als die ersten Trennkontakte 2. Dadurch wird eine geringe Baugröße eines erfindungsgemäßen Fehlerstromschutzschalters 1 unterstützt. Um die Sicherheit im Betrieb der zweiten Trennkontakte 4 zu erhöhen, ist gemäß einer bevorzugten Weiterbildung der gegenständlichen Erfindung vorgesehen, dass seriell zu den zweiten Trennkontakten 4 wenigstens eine, die ersten Trennkontakte 2 ebenfalls überbrückende Sicherung 17 angeordnet ist, wobei insbesondere vorgesehen ist, dass seriell zu jedem der zweiten Trennkontakte wenigstens eine Sicherung 17 angeordnet ist. Die Sicherungen 17 schützen dabei die zweiten Trennkontakte 4 im Falle eines während des Prüfvorganges in dem Netz auftretenden Kurzschlusses vor Verschweißen.

Gemäß einer bevorzugten Ausbildung der gegenständlichen Erfindung ist vorgesehen, dass ein zweiter Hilfskontakt 13 mit den zweiten Trennkontakten 4 mechanisch gekoppelt ist. Dieser zweite Hilfskontakt 13, welcher aufgrund der mechanischen Koppelung dieselbe Schaltstellung aufweist, wie die zweiten Trennkontakte 4 ist schaltungstechnisch an die Steuereinheit 6 angeschlossen, wodurch diese in der Lage ist die Schaltstellung der zweiten Trennkontakte 4 abzufragen.

Bevorzugt ist ebenso vorgesehen, dass ein erster Hilfskontakt 12 mit den ersten Trennkontakten 2 mechanisch gekoppelt ist, wobei dieser erste Hilfskontakt 12 ebenfalls bevorzugt an die Steuereinheit 6 angeschlossen ist, wodurch diese in der Lage ist die Schaltstellung der ersten Trennkontakte 2 abzufragen.

In den Fig. 1 bis 3 ist weiters eine nicht näher bezeichnete Last 25 in Form eines ohmschen Widerstandes eingetragen. Weiters sind gewisse funktionale Baugruppen, welche für die Auslösung des Fehlerstromschutzschalters 1 erforderlich sind, in den Fig. 1 bis 3 in einem Block 28 angeordnet, welche jedoch bevorzugt selbst keine Funktion aufweisen kann. Erfindungsgemäße Fehlerstromschutzschalter 1 weisen weiters eine Prüfanordnung zur Funktionsprüfung des ersten und des zweiten Auslösestromkreises auf. Die Prüfanordnung umfasst dabei einen Prüftaster 7, welcher schaltungstechnisch mit der Steuereinheit 6 wirkverbunden ist, und mit welchem der Steuereinheit 6 der Auftrag zur Durchführung einer Prüfung übermittelt wird. Die weitere Funktionsprüfung erfolgt durch die Steuereinheit 6 gesteuert und wird im Anschluss an die Beschreibung des konstruktiven Aufbaus eines erfindungsgemäßen Fehlerstromschutzschalters 1 dargelegt.

Die Prüfanordnung weist einen ersten Prüfstrompfad 9 auf, welcher zum Erzeugen eines, auf den ersten Auslösestromkreis wirkenden ersten simulierten Fehlerstroms vorgesehen und ausgebildet ist. Der erste Prüfstrompfad 9 weist hiezu, gemäß der dargestellten bevorzugten Ausführungsform, einen Prüfwiderstand 22 und einen ersten Prüfschalter 8 auf, welcher erste Prüfschalter 8 mit der Steuereinheit 6 wirkverbunden ist, und von dieser angesteuert wird. Der erste Prüfstrompfad 9 umfasst weiters eine elektrische Leitung, welche von dem Leiter L des zu schützenden Netzes, außen am Summenstromwandler des ersten Fehlerstromsensors 3 vorbei, zu dem ersten Prüfschalter 8 führt, von diesem weiter zum Prüfwiderstand 22, und mittels einer weiteren Leitung zum Leiter N des Netzes. Derart verbindet der erste Prüfstrompfad 9 zwei Leiter N, L eines zu schützenden elektrischen Netzes, und überbrückt dabei den ersten Fehlerstromsensor 3.

Die Prüfanordnung weist weiters einen zweiten Prüfstrompfad 11 auf, welcher zum Erzeugen eines, auf den zweiten Auslösestromkreis wirkenden zweiten simulierten Fehlerstroms vorgesehen und ausgebildet ist. Der zweite Prüfstrompfad 11 weist hiezu, gemäß der dargestellten bevorzugten Ausführungsform, einen Prüfwiderstand 22 und einen zweiten Prüfschalter 10 auf, welcher zweite Prüfschalter 10 mit der Steuereinheit 6 wirkverbunden ist, und von dieser angesteuert wird. Der zweite Prüfstrompfad 11 umfasst weiters eine elektrische Leitung, welche von dem Leiter L des zu schützenden Netzes, außen am Summenstromwandler des zweiten Fehlerstromsensors 5 vorbei, zu dem zweiten Prüfschalter 10 führt, von diesem weiter zum Prüfwiderstand 22, und mittels einer weiteren Leitung zum Leiter N des Netzes. Derart verbindet der zweite Prüfstrompfad 11 zwei Leiter N, L eines zu schützenden elektrischen Netzes, und überbrückt dabei den zweiten Fehlerstromsensor 5. Besonders bevorzugt ist, wie dargestellt vorgesehen, dass der erste und der zweite Prüfstrompfad 9, 11 jeweils denselben Prüfwiderstand 22 nutzen, daher, dass der Prüfwiderstand 22 Teil des ersten, wie auch des zweiten Prüfstrompfades 9, 11 ist.

Bevorzugt sind der erste Prüfstrompfad 9 und der zweite Prüfstrompfad 11 jeweils derart angeordnet, dass ein eventuell auftretender anlagenbedingter Ableitstrom einmal addiert, und einmal subtrahiert wird. Im Falle einer Addition eines Ableitstromes zu einem Prüfstrom, würde ein höherer Fehlerstrom als beabsichtigt erzeugt. Sollte der Fehlerstromschutzschalter unter diesen Bedingungen auslösen, kann daher nicht darauf geschlossen werden, dass der betreffende Fehlerstromschutzschalter auch bei Nennfehlerstrom auslösen würde. Weiters kann erwartet werden, dass bei Subtraktion des Ableitstromes vom Teststrom der Fehlerstromschutzschalter nicht auslösen wird, da der Nennfehlerstrom unterschritten wird. Ein derartiger Fehlerstromschutzschalter würde daher fälschlicherweise für funktionsuntüchtig angesehen werden. Durch die bevorzugte Auswertung der ersten und zweiten Fehlerstromsignale durch die Steuereinheit 6 kann auf das Auftreten derartiger Ableitströme geschlossen werden, welche auch das Auslöseverhalten im Prüffall überlagern. Dadurch kann tatsächlich die Funktion des Fehlerstromschutzschalters bei Nennstrom geprüft werden, bzw. gegebenenfalls eine Warnung für den Benutzer generiert werden.

Die Ausbildung des ersten und/oder zweiten Prüfstrompfades 9, 11 kann dabei schaltungstechnisch bzw. konstruktiv auch alternativ zur vorstehend beschriebenen bevorzugten Ausführungsform ausgeführt sein.

Der erste und/oder der zweite Prüfschalter 8, 10 sind bevorzugt als elektromechanische Relais ausgebildet, es können jedoch auch andere Schalter, etwa Halbleiterschalter, insbesondere Thyristoren oder Transistoren, vorgesehen sein.

Neben den bereits beschriebenen Baugruppen einer bevorzugten Ausführungsform eines erfindungsgemäßen Fehlerstromschutzschalters 1 ist gemäß einer besonders bevorzugten Weiterbildung der gegenständlichen Erfindung vorgesehen, dass der Fehlerstromschutzschalter 1 wenigstens einen ersten - von der Steuereinheit 6 angesteuerten - Aktuator aufweist, welcher mit den ersten Trennkontakten 2 mechanisch gekoppelt ist. Dadurch kann die Steuereinheit das Schließen und/oder Öffnen der ersten Trennkontakte verursachen.

Die gegenständliche Erfindung betrifft neben der konstruktiven Ausgestaltung eines Fehlerstromschutzschalters 1 weiters ein Verfahren zur Funktionsprüfung eines, insbesondere erfindungsgemäßen, Fehlerstromschutzschalters 1, mit einem ersten Auslösestromkreis und einem zweiten Auslösestromkreis, sowie mit geschlossenen ersten Trennkontakten 2, wobei ein zu schützendes elektrisches Netz vom ersten Auslösestromkreis netzspannungsunabhängig auf das Auftreten von Fehlerströmen überwacht wird, wobei bei Betätigung eines Prüftasters 7, die ersten Trennkontakte 2 überbrückende, zweite Trennkontakte 4 geschlossen werden, wobei nachfolgend ein zweiter simulierter Fehlerstrom zum Testen des zweiten Auslösestromkreises erzeugt wird, wobei ein durch den zweiten Auslösestromkreis ermitteltes zweites Fehlerstromsignal elektrisch verstärkt und auf das Über- oder Unterschreiten eines vorgebbaren Auslösegrenzwerts überprüft wird, und bei Über- oder Unterschreiten des Auslösegrenzwerts durch das zweite Fehlerstromsignal die zweiten Trennkontakte 4 geöffnet werden, wobei, vorzugsweise nur, bei Überschreiten des Auslösegrenzwerts durch das zweite Fehlerstromsignal nachfolgend die zweiten Trennkontakte 4 geschlossen werden, wobei nachfolgend ein erster simulierter Fehlerstrom zum Testen des ersten Auslösestromkreises erzeugt wird, wobei ein durch den ersten Auslösestromkreis ermitteltes erstes Fehlerstromsignal netzspannungsunabhängig auf das Überschreiten eines vorgebbaren Auslösegrenzwerts überprüft wird, wobei bei Überschreiten des Auslösegrenzwerts durch das erste Fehlerstromsignal die ersten Trennkontakte 2 geöffnet werden.

Es sei darauf hingewiesen, dass sich die Angaben eines ersten und eines zweiten simulierter Fehlerstroms bzw. eines ersten und zweiten Fehlerstromsignals nicht auf die zeitliche Reihenfolge deren Entstehung beziehen müssen, sondern bevorzugt im Hinblick auf die Bezeichnung der beteilten Vorrichtungen ausgewählt wurde. Daher bedeutet die Bezeichnung erster simulierter Fehlerstrom nicht, dass dieser zwingend als erster erzeugt wird, sondern, dass dieser durch den ersten Prüfstrompfad erzeugt wird, und zum Prüfen des ersten Auslösestromkreises vorgesehen ist.

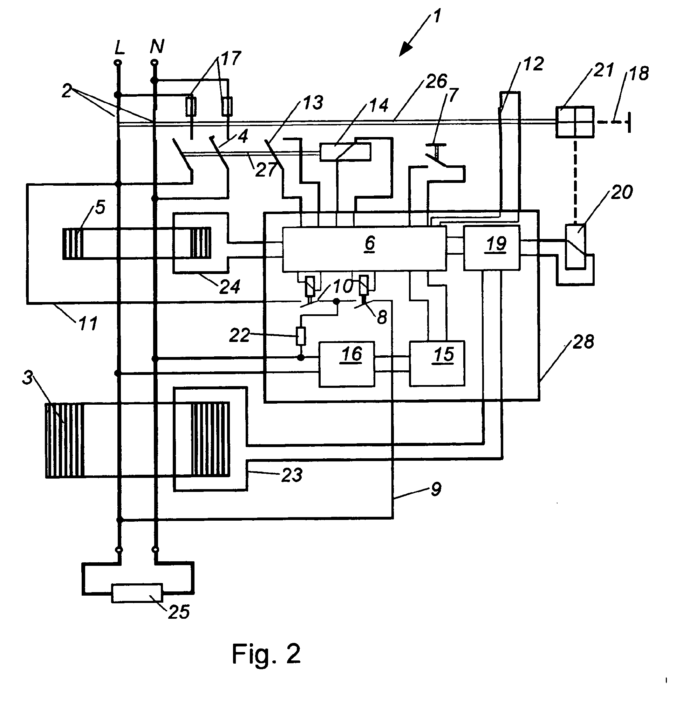

Das zu schützende elektrische Netz wird während des fehlerfreien und prüfungsfreien Betriebs des Fehlerstromschutzschalters 1 vom ersten Auslösestromkreis netzspannungsunabhängig auf das Auftreten von Fehlerströmen überwacht. Der betreffende Zustand ist in Fig. 2 dargestellt.

Bei Betätigung des Prüftasters 7 werden die zweiten Trennkontakte 4, insbesondere durch die Steuereinheit 6, geschlossen, und dadurch die ersten Trennkontakte 2 überbrückt. Mithilfe des optionalen zweiten Hilfskontaktes 13 wird dabei bevorzugt die Schaltstellung der zweiten Trennkontakte 4 durch die Steuereinheit 6 überwacht, wodurch eine mögliche Fehlerquelle des Verfahrens sicher überwacht wird. Dadurch können etwa verschweißte Kontakte der zweiten Trennkontakte 4 erkannt werden.

Nachfolgend wird ein zweiter simulierter Fehlerstrom zum Testen des zweiten Auslösestromkreises erzeugt. Hiebei ist bevorzugt vorgesehen, dass zur Erzeugung des zweiten simulierten Fehlerstroms durch die Steuereinheit 6 ein zweiter Prüfstrompfad 11 für eine vorgebbare zweite Zeitspanne geschlossen wird. Die zweite Zeitspanne ist dabei bevorzugt kürzer als eine Sekunde, insbesondere etwa 300 ms bis 500 ms. Aufgrund der geringen Zeitdauer des gesamten Prüfungsvorganges können die hiefür erforderlichen Komponenten hinsichtlich der abführbaren Verlustleistung, sowie der Energieversorgung klein ausgeführt werden.

Ein als Folge des simulierten zweiten Fehlerstromes durch den zweiten Auslösekreis ermitteltes zweites Fehlerstromsignal wird, etwa in der Steuereinheit 6 bzw. einem separaten Verstärker, elektrisch verstärkt, und auf das Über- oder Unterschreiten eines vorgebbaren und gespeicherten Auslösegrenzwerts überprüft. Sowohl bei einem Über- als auch bei einem Unterschreiten des Auslösegrenzwerts durch das zweite Fehlerstromsignal werden die zweiten Trennkontakte 4 geöffnet. Sofern das zweite Fehlerstromsignal den Auslösegrenzwert überschreitet, bzw. bei einer exakten Übereinstimmung der beiden Werte, ist nachfolgend vorgesehen, dass die zweiten Trennkontakte 4 geschlossen werden. Im Falle eines Unterschreiten des Auslösegrenzwertes durch das zweite Fehlerstromsignal ist vorgesehen, die zweiten Trennkontakte 4 nicht wieder zu schließen, sondern die Prüfung abzubrechen, und - etwa mittels eines Kontrolllichts - einen Fehler anzuzeigen.

Im Falle, dass das zweite Fehlerstromsignal den Auslösegrenzwert überschritten hat, und nachfolgend die zweiten Trennkontakte 4 wieder geschlossen wurden, was optional über den zweiten Hilfskontakt 13 durch die Steuereinheit 6 überprüft wird, wird in weiterer Folge ein erster simulierter Fehlerstrom zum Testen des ersten Auslösestromkreises erzeugt. Hiebei ist bevorzugt vorgesehen, dass zur Erzeugung des ersten simulierten Fehlerstroms durch die Steuereinheit 6 ein erster Prüfstrompfad 9 für eine vorgebbare erste Zeitspanne geschlossen wird. Die erste Zeitspanne ist dabei bevorzugt kürzer als eine Sekunde, insbesondere etwa 300 ms bis 500 ms.

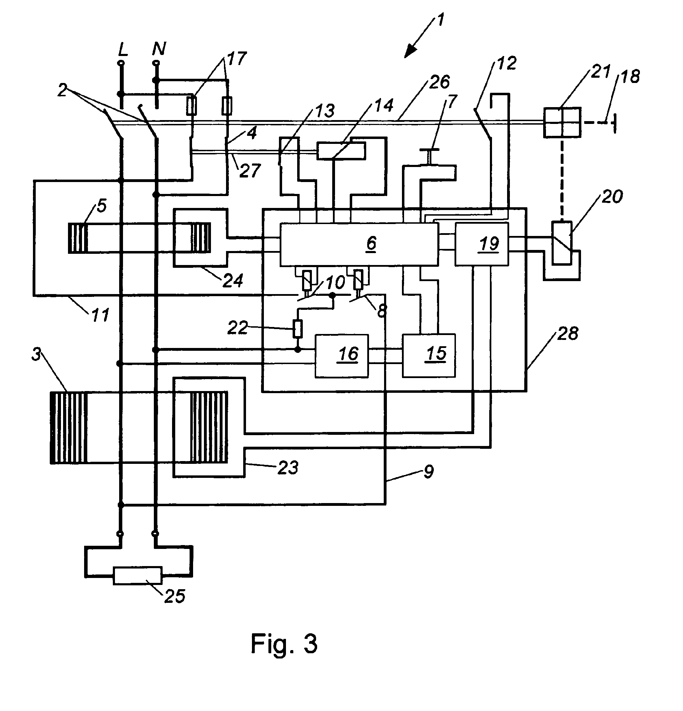

Ein als Folge des simulierten ersten Fehlerstromes durch den ersten Auslösekreis ermitteltes erstes Fehlerstromsignal wird netzspannungsunabhängig auf das Überschreiten eines vorgebbaren Auslösegrenzwerts überprüft, wobei bei Überschreiten des Auslösegrenzwerts durch das erste Fehlerstromsignal die ersten Trennkontakte 2 geöffnet werden. Der entsprechende Zustand ist in Fig. 3 dargestellt. Hiebei kann bevorzugt vorgesehen sein, dass das erste Fehlerstromsignal zusätzlich durch die Steuereinheit 6 eingelesen und überwacht wird, und/oder dass auch weitere elektrische Zustände, wie etwa die Ladekurve eines bevorzugt in der Auslöseeinheit 19 angeordneten Energiespeicherelements, durch die Steuereinheit 6 überwacht werden. Nachfolgend ist bevorzugt vorgesehen, dass die ersten Trennkontakte 2, insbesondere von der Steuereinheit 6 verursacht, geschlossen werden. Während die ersten Trennkontakte 2 geöffnet sind, fließt der Laststrom über die zweiten Trennkontakte 4, während der zweite Auslösestromkreis den Fehlerstromschutz gewährleistet. In Weiterbildung ist bevorzugt vorgesehen, die Energie für das automatische Schließen der ersten Trennkontakte 2 bereits bei Betätigung des Prüftasters 7 in einem weiteren - nicht dargestellten - Energiespeicherelement zu speichern, wodurch dieser Vorgang nicht von der Netzspannung abhängig ist, und der Fehlerstromschutzschalter 1 auch bei einem zwischenzeitlichen Verlust der Netzspannung wieder eingeschaltet werden kann.

Durch die vorstehend dargelegten Verfahrensschritte können die eingangs geltend gemachten Vorteile erzielt werden.

Während der Funktionsprüfung des ersten Auslösestromkreises, insbesondere ausschließlich während dieser Funktionsprüfung, wird das zu schützende elektrische Netz vom zweiten Auslösestromkreis auf das Auftreten von Fehlerströmen überwacht. Dabei ist bevorzugt vorgesehen, dass die Steuereinheit 6 während der Funktionsprüfung des zweiten Auslösestromkreises durch ein Energiespeicherelement 15 mit elektrischer Energie versorgt wird. Dadurch wird eine faktische Unabhängigkeit von der Netzspannung erreicht, da die für den zeitlich begrenzten Betrieb der Steuereinheit erforderliche elektrische Energie dem Energiespeicherelement 15 entnommen wird. In dem Energiespeicherelement 15 ist dabei bevorzugt so viel Energie gespeichert, um den zweiten Auslösestromkreis bei Unterbrechung eines Leiters L, N des zu schützenden Netzes während dessen Betrieb bis zum Wiedereinschalten des ersten Auslösestromkreises zuverlässig versorgen zu können oder andererseits bei Leiterunterbrechung und gleichzeitigem Fehlerstrom die zweiten Trennkontakte 4 abschalten zu können.

Gemäß einer besonders bevorzugten Weiterbildung eines erfindungsgemäßen Verfahrens ist vorgesehen, dass, sofern nach erfolgreicher Prüfung des ersten Auslösestromkreises die ersten Trennkontakte nicht innerhalb einer vorgebbaren Zeitspanne, vorzugsweise kürzer als 5 Sekunden, insbesondere ca. 3 Sekunden, wieder geschlossen werden, die zweiten Trennkontakte 4 durch die Steuereinheit geöffnet werden. Dadurch kann die Miniaturisierung der zweiten Trennkontakte weiter unterstützt werden, da diese lediglich für einen kurzzeitigen Stromfluss ausgelegt werden müssen.

Weiters ist bevorzugt vorgesehen, dass die Steuereinheit 6 derart ausgebildet ist, dass beim Auftreten von Zuständen bzw. Verfahrensabläufen, welche von den vorstehend Beschriebenen abweichen, ein Fehlersignal ausgegeben abgezeigt bzw. weitergeleitet wird.

Sollte es während des Prüfvorganges zu einem Einbruch der Spannung in dem zu schützenden Netz kommen, werden bevorzugt die zweiten Trennkontakte 4 durch die Steuereinheit 6 geöffnet, und der Prüfvorgang abgebrochen.

## Patentansprüche

1. Fehlerstromschutzschalter (1) mit einem ersten Auslösestromkreis und einem zweiten Auslösestromkreis, wobei der Fehlerstromschutzschalter (1) vorgebbar trennbare erste Trennkontakte (2) aufweist, wobei der erste Auslösestromkreis wenigstens einen ersten Fehlerstromsensor (3) aufweist, und zum netzspannungsunabhängigen Öffnen der ersten Trennkontakte (2) beim Auftreten eines Fehlerstromes vorgebbarer Größe mit den ersten Trennkontakten (2) wirkverbunden ist, wobei der Fehlerstromschutzschalter (1) vorgebbar betätigbare zweite Trennkontakte (4) aufweist, welche im geschlossenen Zustand die ersten Trennkontakte (2) überbrücken, wobei der zweite Auslösestromkreis wenigstens einen zweiten Fehlerstromsensor (5) aufweist, wobei der zweite Fehlerstromsensor (5) wenigstens mittelbar mit einer Steuereinheit (6) schaltungstechnisch verbunden ist, wobei die Steuereinheit (6) mit den zweiten Trennkontakten (4) wirkverbunden ist, wobei der Fehlerstromschutzschalter (1) eine Prüfanordnung zur Funktionsprüfung des ersten und des zweiten Auslösestromkreises aufweist, wobei die Prüfanordnung einen Prüftaster (7) aufweist, welcher auf die Steuereinheit (6) wirkt, wobei die Steuereinheit (6) mit einem ersten Prüfschalter (8) wirkverbunden ist, welcher erste Prüfschalter (8) Teil eines ersten Prüfstrompfades (9) zum Erzeugen eines, auf den ersten Auslösestromkreis wirkenden ersten simulierten Fehlerstroms ist, und wobei die Steuereinheit (6) mit einem zweiten Prüfschalter (10) wirkverbunden ist, welcher zweite Prüfschalter (10) Teil eines zweiten Prüfstrompfades (11) zum Erzeugen eines, auf den zweiten Auslösestromkreis wirkenden zweiten simulierten Fehlerstroms ist.

2. Fehlerstromschutzschalter (1) nach Anspruch 1, **dadurch gekennzeichnet, dass** ein erster Hilfskontakt (12) mit den ersten Trennkontakten (2) mechanisch gekoppelt ist, und/oder dass ein zweiter Hilfskontakt (13) mit den zweiten Trennkontakten (4) mechanisch gekoppelt ist.

3. Fehlerstromschutzschalter (1) nach Anspruch 1 oder 2, **dadurch gekennzeichnet, dass** der Fehlerstromschutzschalter (1) wenigstens einen ersten - von der Steuereinheit (6) angesteuerten - Aktuator aufweist, welcher mit den ersten Trennkontakten (2) mechanisch gekoppelt ist.

4. Fehlerstromschutzschalter (1) nach einem der Ansprüche 1 bis 3, **dadurch gekennzeichnet, dass** der Fehlerstromschutzschalter (1) wenigstens einen zweiten - von der Steuereinheit (6) angesteuerten - Aktuator (14) aufweist, welcher mit den zweiten Trennkontakten (4) mechanisch gekoppelt ist.

5. Fehlerstromschutzschalter (1) nach einem der Ansprüche 1 bis 4, **dadurch gekennzeichnet, dass** die Steuereinheit (6) - zur Energieversorgung - mit einem Energiespeicherelement (15), insbesondere einen Akkumulator oder einen Kondensator, schaltungstechnisch verbunden ist, welches Energiespeicherelement (15) mit einem Netzteil (16) verbunden ist.

6. Fehlerstromschutzschalter (1) nach einem der Ansprüche 1 bis 5, **dadurch gekennzeichnet, dass** der erste Prüfstrompfad (9) zwei Leiter (N, L) eines zu schützenden elektrischen Netzes verbindet, und dabei den ersten Fehlerstromsensor (3) überbrückt, und/oder dass der zweite Prüfstrompfad (11) zwei Leiter (N, L) des zu schützenden elektrischen Netzes verbindet, und dabei den zweiten Fehlerstromsensor (5) überbrückt.

7. Fehlerstromschutzschalter (1) nach einem der Ansprüche 1 bis 6, **dadurch gekennzeichnet, dass** seriell zu den zweiten Trennkontakten (4) wenigstens eine, die ersten Trennkontakte (2) ebenfalls überbrückende Sicherung (17) angeordnet ist.

8. Verfahren zur Funktionsprüfung eines Fehlerstromschutzschalters (1), insbesondere nach einem der Ansprüche 1 bis 7, mit einem ersten Auslösestromkreis und einem zweiten Auslösestromkreis, einer Steuereinheit (6), sowie mit geschlossenen ersten Trennkontakten (2), wobei ein zu schützendes elektrisches Netz vom ersten Auslösestromkreis netzspannungsunabhängig auf das Auftreten von Fehlerströmen überwacht wird, wobei bei Betätigung eines Prüftasters (7), die ersten Trennkontakte (2) überbrückende, zweite Trennkontakte (4) geschlossen werden, wobei nachfolgend ein zweiter simulierter Fehlerstrom zum Testen des zweiten Auslösestromkreises erzeugt wird, wobei ein durch den zweiten Auslösestromkreis ermitteltes zweites Fehlerstromsignal elektrisch verstärkt und auf das Über- oder Unterschreiten eines vorgebbaren Auslösegrenzwerts überprüft wird, und bei Über- oder Unterschreiten des Auslösegrenzwerts durch das zweite Fehlerstromsignal die zweiten Trennkontakte (4) geöffnet werden, wobei, vorzugsweise nur, bei Überschreiten des Auslösegrenzwerts durch das zweite Fehlerstromsignal nachfolgend die zweiten Trennkontakte (4) geschlossen werden, wobei nachfolgend ein erster simulierter Fehlerstrom zum Testen des ersten Auslösestromkreises erzeugt wird, wobei ein durch den ersten Auslösestromkreis ermitteltes erstes Fehlerstromsignal netzspannungsunabhängig auf das Überschreiten eines vorgebbaren Auslösegrenzwerts überprüft wird, wobei bei Überschreiten des Auslösegrenzwerts durch das erste Fehlerstromsignal die ersten Trennkontakte (2) geöffnet werden.

9. Verfahren nach Anspruch 8, **dadurch gekennzeichnet, dass** nachfolgend die ersten Trennkontakte (2), insbesondere von der Steuereinheit (6) verursacht, geschlossen werden.

10. Verfahren nach Anspruch 8 oder 9, **dadurch gekennzeichnet, dass** zur Erzeugung des zweiten simulierten Fehlerstroms durch die Steuereinheit (6) ein zweiter Prüfstrompfad (11) für eine vorgebbare zweite Zeitspanne geschlossen wird.

11. Verfahren nach einem der Ansprüche 8 bis 10, **dadurch gekennzeichnet, dass** zur Erzeugung des ersten simulierten Fehlerstroms durch die Steuereinheit (6) ein erster Prüfstrompfad (9) für eine vorgebbare erste Zeitspanne geschlossen wird.

12. Verfahren nach einem der Ansprüche 8 bis 11, **dadurch gekennzeichnet, dass**, lediglich während der Funktionsprüfung des ersten Auslösestromkreises, das zu schützende elektrische Netz vom zweiten Auslösestromkreis auf das Auftreten von Fehlerströmen überwacht wird.

13. Verfahren nach einem der Ansprüche 8 bis 12, **dadurch gekennzeichnet, dass** die zweiten Trennkontakte (4) von der Steuereinheit (6) betätigt werden und deren Schaltstellung von der Steuereinheit (6) überwacht wird.

14. Verfahren nach einem der Ansprüche 8 bis 13, **dadurch gekennzeichnet, dass** die Steuereinheit (6) während der Funktionsprüfung des zweiten Auslösestromkreises durch ein Energiespeicherelement (15) mit elektrischer Energie versorgt wird.

15. Verfahren nach einem der Ansprüche 8 bis 14, **dadurch gekennzeichnet, dass** ein - im Zuge der Funktionsprüfung - durch den ersten Auslösestromkreis erzeugtes erstes Fehlerstromsignal zusätzlich durch die Steuereinheit (6) eingelesen und überwacht wird.

## Claims

1. Residual current circuit breaker (1) with a first triggering circuit and a second triggering circuit, wherein the residual current circuit breaker (1) has separable first isolating contacts (2), wherein the first triggering circuit has at least a first residual current sensor (3) and is operatively connected to the first isolating contacts (2) to allow for an opening of the first isolating contacts (2) independently of the mains/network voltage if a residual current of specifiable size occurs, wherein the residual current circuit breaker (1) has specifiable activatable second isolating contacts (4), which bridge the first isolating contacts (2) in a closed state, wherein the second triggering circuit has at least a second residual current sensor (5), wherein the second residual current sensor (5) is electrically connected at least indirectly to a control unit (6), wherein the control unit (6) is operatively connected to the second isolating contacts (4), wherein the residual current circuit breaker (1) has a test arrangement for a function test of the first and the second triggering circuit, wherein the test arrangement comprises a test push button (7), which acts on the control unit (6), wherein the control unit (6) is operatively connected to a first test switch (8), which first test switch (8) is part of a first test current path (9) for generating of a first simulated residual current acting on the first triggering circuit, and wherein the control unit (6) is operatively connected to a second test switch (10) which second test switch (10) is a part of a second test current path (11) for generating a second simulated residual current acting on the second triggering circuit.

2. Residual current circuit breaker (1) according to Claim 1, **characterised in that** a first auxiliary contact (12) is mechanically coupled to the first isolating contacts (2), and/or that a second auxiliary contact (13) is mechanically coupled to the second isolating contacts (4).

3. Residual current circuit breaker (1) according to Claim 1 or 2, **characterised in that** the residual current circuit breaker (1) has at least a first actuator controlled by the control unit (6), which is mechanically coupled to the first isolating contacts (2).

4. Residual current circuit breaker (1) according to one of the Claims 1 through 3, **characterised in that** the residual current circuit breaker (1) has at least a second actuator (14) controlled by the control unit (6), which is mechanically coupled to the second isolating contacts (4).

5. Residual current circuit breaker (1) according to one of the Claims 1 through 4, **characterised in that** the control unit (6) is electrically connected - for energy supply - to an energy storage element (15), particularly an accumulator or a capacitor, which in turn is connected to a power unit (16).

6. Residual current circuit breaker (1) according to one of the Claims 1 through 5, **characterised in that** the first test current path (9) connects two conductors (N, L) of an electrical network to be protected, thus bridging the first residual current sensor (3), and/or that the second test current path (11) connects two conductors (N, L) of the electrical network to be protected, thus bridging the second residual current sensor (5).

7. Residual current circuit breaker (1) according to one of the Claims 1 through 6, **characterised in that** at least one fuse (17) also bridging the first isolating contacts (2) is arranged in series to the second isolating contacts (4).

8. Method for the function test of a residual current circuit breaker (1), particularly according to one of claims 1 to 7, with a first triggering circuit and a second triggering circuit, a control unit (6), as well as closed first isolating contacts (2), wherein an electrical network to be protected is monitored by the first triggering circuit for the occurrence of residual current, independent from the network voltage , wherein upon triggering a test push button (7) second isolating contacts (4) which bridge the first isolating contacts (2), are closed, wherein subsequently a second simulated residual current is generated for testing the second triggering circuit, wherein a second residual current signal determined by the second triggering circuit is electrically amplified and is monitored for a specifiable triggering threshold being exceeded or fallen short, and upon the second residual current signal exceeding or falling below the triggering threshold, the second isolating contacts (4) are opened, wherein preferably only upon the second residual current signal exceeding the triggering threshold subsequently the second isolating contacts (4) are closed, wherein subsequently a first simulated residual current is generated for testing the first triggering circuit, wherein a first residual current signal determined by the first triggering circuit is monitored for the specifiable triggering threshold being exceeded, independently from the network voltage , wherein upon the first residual current signal exceeding the triggering threshold the first isolating contacts (2) are opened.

9. Method according to Claim 8, **characterised in that** subsequently the first isolating contacts (2), are closed, particularly caused by the control unit (6).

10. Method according to Claim 8 or 9, **characterised in that** for the generation of the second simulated residual current by the control unit (6), a second test current path (11) is closed for a specifiable second period.

11. Method according to one of the Claims 8 through 10, **characterised in that** for the generation of the first simulated residual current by the control unit (6), a first test current path (9) is closed for a specifiable first period.

12. Method according to one of the Claims 8 through 11, **characterised in that** the electrical network to be protected is monitored by the second triggering circuit for the occurrence of residual currents only during the function test of the first triggering circuit.

13. Method according to one of the Claims 8 through 12, **characterised in that** the second isolating contacts (4) are activated by the control unit (6) and their switch position is monitored by the control unit (6).

14. Method according to one the Claims 8 through 13, **characterised in that** the control unit (6) is supplied with electrical energy by an energy storage element (15) during the function test of the second triggering circuit.

15. Method according to one the Claims 8 through 14, **characterised in that** a first residual current signal generated - in the course of the function test - by the first triggering circuit is additionally read in and monitored by the control unit (6).

## Revendications

1. Disjoncteur à courant résiduel (1) comportant un premier circuit de déclenchement et un second circuit de déclenchement, le disjoncteur à courant résiduel (1) présentant des premiers contacts de rupture (2) séparables de manière prédéterminée, dans lequel le premier circuit de déclenchement comporte au moins un premier capteur de courant résiduel (3) et est raccordé de manière fonctionnelle aux premiers contacts de rupture (2) pour permettre, indépendamment de la tension de secteur, l'ouverture des premiers contacts de rupture (2) si un courant résiduel d'une taille prédéterminée se produit, le disjoncteur à courant résiduel (1) comportant des seconds contacts de rupture (4) actionnables de manière prédéterminée qui pontent les premiers contacts de rupture (2) à l'état fermé, dans lequel le second circuit de déclenchement présente au moins un second capteur de courant résiduel (5) qui est raccordé électriquement au moins indirectement à une unité de commande (6), laquelle est raccordée de manière fonctionnelle aux seconds contacts de rupture (4), le disjoncteur à courant résiduel (1) comportant un dispositif de test pour le test de fonctionnement du premier et du second circuit de déclenchement, le dispositif de test comprenant un bouton de test (7) qui agit sur l'unité de commande (6), l'unité de commande (6) étant raccordée de manière fonctionnelle à un premier commutateur de test (8), lequel premier commutateur de test (8) fait partie d'un premier trajet de courant de test (9) pour permettre la génération d'un premier courant résiduel simulé qui agit sur le premier circuit de déclenchement, et l'unité de commande (6) étant raccordée de manière fonctionnelle à un second commutateur test, lequel second commutateur de test (10) fait partie d'un second trajet de courant de test (11) pour permettre la génération d'un second courant résiduel simulé qui agit sur le second circuit de déclenchement.

2. Disjoncteur à courant résiduel (1) selon la revendication 1, **caractérisé en ce qu**'un premier contact auxiliaire (12) est couplé mécaniquement aux premiers contacts de rupture (2) et/ou en ce qu'un second contact auxiliaire (13) est couplé mécaniquement aux seconds contacts de rupture (4).

3. Disjoncteur à courant résiduel (1) selon les revendications 1 ou 2, **caractérisé en ce que** le disjoncteur à courant résiduel (1) comporte au moins un premier actionneur, commandé par l'unité de commande (6), qui est couplé mécaniquement aux premiers contacts de rupture (2).

4. Disjoncteur à courant résiduel (1) selon l'une quelconque des revendications 1 à 3, **caractérisé en ce que** le disjoncteur à courant résiduel (1) présente au moins un second actionneur (14), commandé par l'unité de commande (6), qui est couplé mécaniquement aux seconds contacts de rupture (4).

5. Disjoncteur à courant résiduel (1) selon l'une quelconque des revendications 1 à 4, **caractérisé en ce que** l'unité de commande (6) est raccordée électriquement, aux fins d'alimentation électrique, à un élément de stockage d'énergie (15), notamment un accumulateur ou à un condensateur qui est raccordé à une unité d'alimentation (16).

6. Disjoncteur à courant résiduel (1) selon l'une quelconque des revendications 1 à 5, **caractérisé en ce que** le premier trajet de courant de test (9) relie deux conducteurs (N, L) d'un réseau électrique qui doit être protégé, en pontant le premier capteur de courant résiduel (3) et/ou **en ce que** le second trajet de courant de test (11) relie deux conducteurs (N, L) du réseau électrique qui doit être protégé, en pontant le second capteur de courant résiduel (5).

7. Disjoncteur à courant résiduel (1) selon l'une quelconque des revendications 1 à 6, **caractérisé en ce qu**'au moins un fusible (17) qui ponte également les premiers contacts de rupture (2) est monté en série sur les seconds contacts de rupture (4).

8. Procédé permettant d'effectuer un test de fonctionnement d'un disjoncteur à courant résiduel (1), notamment selon l'une quelconque des revendications 1 à 7, comportant un premier circuit de déclenchement et un second circuit de déclenchement, une unité de commande (6) ainsi que des premiers contacts de rupture (2) fermés, dans lequel un réseau électrique qui doit être protégé est surveillé, indépendamment de la tension du réseau, par le premier circuit de déclenchement pour détecter la survenue de courants résiduels, dans lequel, lors du déclenchement d'un bouton de test (7), les seconds contacts de rupture (4) qui pontent les premiers contacts de rupture (2) se ferment, un second courant résiduel simulé étant ensuite généré pour tester le second circuit de déclenchement, un second signal de courant résiduel déterminé par le second circuit de déclenchement étant électriquement amplifié et étant surveillé pour détecter le dépassement ou la non-atteinte d'un seuil de déclenchement prédéterminé et, en cas de dépassement ou de non-atteinte du seuil de déclenchement, les seconds contacts de rupture (4) étant ouverts sous l'effet du second signal de courant résiduel, dans lequel, de préférence seulement en cas de dépassement du seuil de déclenchement, les seconds contacts de rupture (4) sont subséquemment fermés sous l'effet du second signal de courant résiduel, un premier courant résiduel simulé étant généré subséquemment pour tester le premier circuit de déclenchement, un premier signal de courant résiduel déterminé par le premier circuit de déclenchement étant surveillé, indépendamment de la tension du réseau, pour détecter le dépassement d'un seuil de déclenchement prédéterminé et, dans le cas du dépassement dudit seuil de déclenchement, les premiers contacts de rupture (2) étant ouverts par le premier signal de courant résiduel.

9. Procédé selon la revendication 8, **caractérisé en ce que,** par la suite, les premiers contacts de rupture (2) sont fermés, notamment sous l'action de l'unité de commande (6).

10. Procédé selon la revendication 8 ou 9, **caractérisé en ce que,** pour la génération, par l'unité de commande (6), du second courant résiduel simulé, un second trajet de courant de test (11) est fermé pendant une seconde période de temps prédéterminée.

11. Procédé selon l'une quelconque des revendications 8 à 10, **caractérisé en ce que,** pour la génération, par l'unité de commande (6), du premier courant résiduel simulé, un premier trajet de courant de test (9) est fermé pendant une première période de temps prédéterminée.

12. Procédé selon l'une quelconque des revendications 8 à 11, **caractérisé en ce que** le réseau électrique qui doit être protégé est surveillé par le second circuit de déclenchement pour détecter la survenue de courants résiduels et ce, seulement pendant le test de fonctionnement du premier circuit de déclenchement.

13. Procédé selon l'une quelconque des revendications 8 à 12, **caractérisé en ce que** les seconds contacts de rupture (4) sont activés par l'unité de commande (6) et leur position de commutation est surveillée par l'unité de commande (6).

14. Procédé selon l'une quelconque des revendications 8 à 13, **caractérisé en ce que** l'unité de commande (6) est alimentée en énergie électrique par un élément de stockage d'énergie (15) pendant le test de fonctionnement du second circuit de déclenchement.

15. Procédé selon l'une quelconque des revendications 8 à 14, **caractérisé en ce qu**'un premier signal de courant résiduel généré, au cours du test de fonctionnement, par le premier circuit de déclenchement est en outre lu dans l'unité de commande (6) et surveillé par cette dernière.
